# EUROPEAN PATENT APPLICATION

(11) **EP 3 712 964 A1**
(43) Date of publication of application: **23.09.2020**
(21) Application number: 19164107.5
(22) Date of filing: 20.03.2019
(51) Int. Cl.: H01L 31/042, H01L 31/048, H01L 31/05

(54) **METHOD FOR MANUFACTURING OF A PHOTOVOLTAIC MODULE**

(71) Applicant: Sono Motors GmbH, 80935 München (DE)
(72) Inventor: BAUDRIT, Mathieu, 80636 München (DE)
(74) Representative: Qip Patentanwälte Dr. Kuehn & Partner mbB

(57) **Abstract**

The present invention relates to a method for manufacturing a photovoltaic module. The module comprises at least a front layer, a back layer, and a solar cell arrangement encapsulated between the front and back layers. The solar cell arrangement includes a plurality of photovoltaic cells and electrical connections between the cells. In some embodiments the photovoltaic cells are crystalline silicon photovoltaic cells. The method comprises the steps of providing the solar cell arrangement and then injection molding at least part of the front and/or back layer onto the solar cell arrangement.

## Description

### Background

In recent years global trends continue to support the utilization of renewable energy technologies. Given the versatility and modular nature of solar panels, they have come to represent a keystone technology in providing renewable energy for general consumption. As a result, solar modules continue to become more ubiquitous and available to consumers, allowing them to produce their own electricity.

Consequently, a need arises to provide new and innovative ways to incorporate solar cells within the infrastructure of everyday life. One emerging aspect of this challenge is the provision of solar panels within constructions or vehicles to provide for some of the power requirements thereof.

However, present solar cell arrangement technology limits the types of solar cells that may be used and how they may be attached or integrated into a vehicle and other structures.

Generally, in the solar cell field, solar panels are made through lamination. This process substantially limits the types of geometries that may be achieved to flat or almost flat solar panels.

WO 2019/020718 A1 describes a vehicle body part having at least one solar cell which is arranged therein for the purpose of generating electrical energy.

US 2011/0100438 A1 describes photovoltaic devices comprising a photovoltaic cell assembly with an injection molded portion connected to at least one edge of the photovoltaic cell assembly for mounting on the exterior of a building.

EP 1 245 418 A2 discloses a solar panel for incorporation into the frame of an automobile. The solar cells are embedded within a foam-deposited covering layer.

US 5 743 970 B1 describes a photovoltaic module which includes at least one photovoltaic cell which is encapsulated in a non-reacted, injection molded polymeric material.

US 2009/0084432 A1 discloses an injection molded plastic housing for taking up electrical and/or electronic built-in components such as thin-film solar cells.

CN 206367145 U, CN 205167427 U, and CN 102412328 A disclose further solar cell assemblies and injection molding techniques.

However, further improvements for an efficient manufacturing of solar modules continue to be required.

Thus, one object of the present invention is to provide improved methods of photovoltaic module manufacturing and forming that allow for more complex module geometries. Another object is to provide methods allowing for the efficient manufacturing of photovoltaic modules for integration into various structures.

### Summary

At least some of these objects are achieved with the features of the independent claims. Dependent claims refer to preferred embodiments.

As discovered by the present inventors, the integration of solar cells into various items and/or structures may be achieved in an advantageous manner through methods involving injection molding.

According to a first aspect, the invention relates to a method for manufacturing a photovoltaic module. The module comprises a solar cell arrangement including a plurality of photovoltaic cells and electrical connections between the cells. The method comprises the steps of providing the solar cell arrangement and then injection molding a layer onto the solar cell arrangement. The injection molded layer may be at least part of a front layer and/or at least part of a back layer of the photovoltaic module.

The solar cell arrangement may be at least partially or fully encapsulated by the injection molded material, for example between the front layer and the back layer. Such encapsulation could also be referred to as at least partially or fully enclosing the solar cell arrangement in the injection molded material, for example between the front layer and the back layer.

One or more intermediate layers may be present between the solar cell arrangement and the injection molded material. However, the material could also be molded directly onto a portion of the arrangement without such intermediate layer(s) being provided.

The term "onto" is not to be understood as limiting a direction from which the injection molded material is injected onto the solar cell arrangement. As the skilled person will appreciate, depending on the design of the mold and/or of the injection molding machine, injection molded material may be supplied from above, from below and/or from a side into the mold and/or onto the solar cell arrangement.

The photovoltaic cells may be individual photovoltaic cells and the solar cell arrangement may optionally further comprise a carrier mechanically joining and/or mechanically connecting and/or supporting the individual photovoltaic cells. Such a carrier may help to maintain the individual photovoltaic solar cells together and maintain the electrical connections by reducing mechanical stress. The carrier may be made from a flexible material without requiring a rigid confinement of the photovoltaic cells in a certain configuration. The carrier may be made from a material including glass fibers, carbon fibers, Kevlar and/or polymers.

The photovoltaic cells may also be referred to as solar cells in the context of the present disclosure. The solar cells may be provided as one or more strings. The electrical connections may be provided by one or more electrically conducting ribbons and/or one or more copper solderings between two adjacent photovoltaic cells, preferably between each two adjacent photovoltaic cells of a respective string.

The electrical connection between two (or more) solar cells (e.g., the electrical connection between two adjacent cells of a string) can include a release loop. Such release loop may be helpful for accommodating thermal expansion of the materials surrounding the photovoltaic cells, which may be particularly important when employing polymer materials. The release loop may be a portion of the electrical connection configured to at least partially straighten when the solar cell arrangement expands. The release loop can be formed, for example, by providing the electrical connection with a looped portion and/or with an undulating shape. In particular, the electrical connection may be formed with one or more loops and/or undulations extending perpendicular to the longitudinal direction in which the connection extends. The electrical connection, for example, may have a sinusoidal undulating shape. Alternatively or additionally, two portions of the electrical connection (e.g., two straight portions) may be connected by an undulating link. The release loop may be fully encapsulated in and/or enclosed by polymeric material.

Any kind of solar cells can be used, including single to multi junction solar cells, even monocrystalline. For example, crystalline silicon or III-V compounds photovoltaic cells may be used. The photovoltaic cells may be rigid.

The photovoltaic cells may be of any size. The cells may have a size of at least 10 mm x 10 mm, preferably at least 20 mm x 20 mm, more preferably at least 100 mm x 100 mm (regardless of whether the cells are square, rectangular or have any other shape).

Preferably, the photovoltaic cells have a width dimension, a length dimension that is perpendicular to said width dimension, and a thickness dimension that is perpendicular to both the length dimension and to the thickness dimension. The thickness may be smaller than the width dimension and/or than the length dimensions, preferably by at least a factor of 5, 10, 50 or 1000. As such, the cells may be thin.

Preferably, the width and/or the length dimension is at least 10 mm, preferably at least 20 mm, more preferably at least 100 mm. For example, the cells may be rectangular with a length of at least 10 mm, at least 20 mm, or at least 100 mm while the width may be larger or smaller.

The photovoltaic cells may optionally be full size solar cells having a width dimension of 156 mm and a length dimension of 156 mm. The cells may also be larger.

Optionally, the front layer and/or the back layer may form an exposed outer surface of the photovoltaic module.

The molded front layer and/or the molded back layer may have a surface of at least 100 cm², preferably at least 1000 cm², at least 2000 cm², or at least 5000 cm².

Injection molding onto the solar cells or solar cells arrangement provides numerous benefits, as it allows for more complex geometries of photovoltaic modules to be created and said modules can be continuously manufactured with a high degree of fidelity.

Suitable injection molding materials may include thermoplastics, thermosets and elastomers. Materials such as polypropylene (PP), polycarbonate (PC), polyethylene (PE), polytetrafluoroethylene (PTFE), polyoxymethylene (POM), acrylonitrile butadiene styrene (ABS), a polyaryletherketone (PAEK), polyether ether ketone (PEEK), copolymers of polypropylene and ethylene, epoxy, phenolic, nylon, polystyrene (PS) and/or silicone (or any combination thereof) may be used for the injection molded layer(s).

According to the present disclosure, the method may include a step of providing the solar cell arrangement with a substrate and/or superstrate prior to performing the injection molding step. The substrate may be a polymeric foil and/or the superstrate may be a polymeric foil. The injection molding material may then be deposited either directly onto the photovoltaic cells and/or onto material used as the substrate or the superstrate. The substrate and/or superstrate (e.g., the one or more polymeric foils) may provide an additional layer of protection of the photovoltaic cells and/or may hold the photovoltaic cells in position during the injection molding process. The injection molded layer may be thicker and/or harder than the substrate and/or than the superstrate.

The molded layer preferably is either the front or the back layer of the photovoltaic module. Optionally, only the front layer or only the back layer may be injection molded in this case. The substrate or the superstrate of the solar cell arrangement may form the exposed outer surface.

Optionally, the molded layer is injection molded onto a side of the solar cell arrangement opposite to the substrate or superstrate (e.g., opposite to the polymeric foil used as the substrate or superstrate). In such a configuration the injection molded layer may provide the structure and shape of the photovoltaic module while the substrate or superstrate (e.g., the polymeric foil) of the solar cells arrangement can provide some protection on the opposite side from, for example, fluid ingress.

Preferably the method may also include the step of joining the substrate or superstrate (e.g., the foil) together with the photovoltaic cells (e.g., with the one or more strings) and/or with the solar cell arrangement before injection molding the molded layer. This joining may optionally be performed through the application of heat, which in some cases may partially melt the polymeric foil and allow it to attach to the photovoltaic cells. The solar cell arrangement with such superstrate and/or substrate could also be referred to as a "solar cell assembly" in the context of the present invention.

Optionally, the polymeric foil and the string of photovoltaic cells (and/or the solar cell arrangement) may be joined together by a lamination process to form the solar cells arrangement. This lamination process would preferably exclude the use of a rigid sheet, such as a polycarbonate and/or glass sheet, which is traditionally used in a solar cell arrangement lamination process. Lamination of individual solar cells on a rigid sheet often severely limits the spatial configuration of the photovoltaic cells, forcing an arrangement that provides photovoltaic cells which are essentially coplanar. Thus, exclusion of the rigid sheet allows for a wider range of photovoltaic cell configurations and higher degree of flexibility of design. Such flexibility allows for the photovoltaic cells to be utilized in novel locations and for novel purposes.

In the context of the present disclosure, an element (e.g., a sheet) may be considered to be "rigid", for example, if it does not substantially deform under the influence of gravity. For example, when such rigid sheet is stood on a narrow edge thereof, it may deflect somewhat under the influence of gravity, but - under the influence of gravity - preferably does not collapse (e.g., due to its own weight). In contrast, the above-mentioned polymeric foil may be made from a soft and/or flexible material. Optionally, the polymeric foil cannot be stood on a narrow edge thereof without folding and/or collapsing under its own weight.

Alternatively, or additionally to the use of the above-mentioned polymeric foil, the method may include a step of encapsulating the solar cell arrangement and/or one or more strings of photovoltaic cells at least partially or completely in an encapsulation liquid or gel. The encapsulation liquid or gel may be a liquid or gel, respectively, that hardens. The hardening may be due to, for example, the evaporation of volatile components, a chemical reaction (e.g., a polymerization) and/or the influence of heat and/or UV light. The encapsulated solar cell arrangement could also be referred to as a "solar cell assembly". Subsequently, the front layer and/or the back layer may then be injection molded directly onto the encapsulated solar cell arrangement. For example, the front layer and/or the back layer may be injection molded directly onto the encapsulation liquid or gel, preferably after it has at least partially hardened. Encapsulation of the photovoltaic cells provides for a further barrier of the photovoltaic cells against fluid ingress, oxidation, and further damaging environmental effects. Furthermore, the encapsulation may hold the photovoltaic cells in position during the injection molding process.

Irrespective of whether a polymeric foil or an encapsulation liquid or gel is used, the solar cell assemblies described above preferably are manufactured in a flat or essentially flat configuration. This may facilitate production, in particular when using a lamination technique. Such flat or essentially flat solar cell assembly may be bent somewhat (preferably, only slightly) when inserted into the injection molding mold. This may include a bending of the photovoltaic cells within acceptable limits. Alternatively, the solar cell assembly could be manufactured with a curved shape. This may facilitate subsequent production steps and may allow for a stronger curvature and/or sharper bends of the module.

Alternatively or additionally to the use of the above-mentioned polymeric foil and/or encapsulation, the risk of the cells being misaligned during injection molding may also be reduced by providing the mold with one or more recesses and/or one or more protrusions for holding the photovoltaic cells, the solar cell arrangement or the solar cell assembly in place in the mold. For example, each solar cell and/or the solar cell arrangement may be arranged in a corresponding recess and/or each cell, the solar cell arrangement or the solar cell assembly may be retained by a corresponding retainer arrangement. The retainer arrangement may comprise one or more protrusions. Alternatively or additionally, the injection molding mold may be configured to clamp the solar cell arrangement and/or its photovoltaic cells between two movable mold parts, e.g. between two halves of the mold.

Alternatively or additionally to the use of the above-mentioned polymeric foil and/or to the use of the above-mentioned encapsulation liquid and/or the above-mentioned recesses, protrusions and/or clamping, the method may include a first injection molding step wherein a first molded layer is injection molded onto the photovoltaic cells, the solar cell arrangement or the solar cell assembly and a second injection molding step wherein a second molded layer is injection molded onto the first molded layer, the photovoltaic cells, the solar cell arrangement and/or the solar cell arrangement. Optionally, the first injection molding step is performed directly onto the photovoltaic cells or solar cells arrangement.

The first molded layer may form the front layer while the second molded layer may form the back layer of the solar photovoltaic module, or vice-versa. Providing both the front layer and the back layer as injection molded layers has the advantage of protecting the photovoltaic cells from both sides, and may optionally completely encapsulate or embed the photovoltaic cells within the injection molded material(s). This may protect the photovoltaic cells from environmental damage and may allow for direct inclusion in various technologies. Moreover, the process may be easier to automate.

Optionally, the first injection molding step is carried out at a lower pressure than the second injection molding step. Such a method may be particularly useful if the injection molding step is performed directly onto the photovoltaic cells when the photovoltaic cells are unsupported (e.g., by a rigid sheet). As the photovoltaic cells may then be fragile and/or movable in the injection molding mold, performing the first injection molding step at a lower pressure may help to prevent damage to the cells and/or a misalignment of the cells in the photovoltaic module. Once the first injection molding step is performed, the photovoltaic cells may be better stabilized and supported. The second injection molding step may then be performed at a higher pressure, if desired.

Optionally a first polymeric composition is injected in the first injection molding step and a second polymeric composition is injected in the second injection molding step. Preferably, one of the first and second compositions is transparent while the other is translucent or opaque. Optionally, the first composition may be transparent while the second composition may be colored. The transparent layer is then preferably formed on a side of the photovoltaic module and/or on a side of the photovoltaic cells configured to face the sun and/or to receive sunlight in order to produce electricity. The first and second compositions may also have different colors. The first composition may form the front layer of the photovoltaic module. The second composition may form the back layer of the photovoltaic module.

Optionally the first composition includes a different type of polymer than the second composition. The first composition may include a first polymer forming the matrix of the first molded layer, e.g. a first thermoplastic or thermosetting polymer. The second composition may include a second polymer forming the matrix of the second molded layer, e.g. a second thermoplastic or thermosetting polymer. The first and second polymers may have different structural formulas. Alternatively or additionally, one of the compositions may include reinforcing fibers (e.g., carbon fibers, glass fibers and/or Kevlar fibers) while the other one does not, or the first and second compositions may include a different amount of such reinforcing fibers. This may be helpful for adjusting the mechanical and/or optical properties of the front and back layers. For example, the first polymer may be or may include materials such as polypropylene (PP), polyurethane (PU) polycarbonate (PC), polyethylene (PE), polytetrafluoroethylene (PTFE), polyoxymethylene (POM), acrylonitrile butadiene styrene (ABS), a polyaryletherketone (PAEK), polyether ether ketone (PEEK), copolymers of polypropylene and ethylene, epoxy, phenolic, nylon, polystyrene (PS) and/or silicone (or any combination thereof). The second polymer may include materials such as polypropylene (PP), polyurethane (PU), polycarbonate (PC), polyethylene (PE), polytetrafluoroethylene (PTFE), polyoxymethylene (POM), acrylonitrile butadiene styrene (ABS), a polyaryletherketone (PAEK), polyether ether ketone (PEEK), copolymers of polypropylene and ethylene, epoxy, phenolic, nylon, polystyrene (PS) and/or silicone (or any combination thereof). Any combination of these materials may be used, as appropriate. Further, the provision of two different compositions for the first and second polymers may aid in performing a first and second injection molding steps at different pressures.

Preferably, the first injection molding step is carried out in a mold comprising at least a first mold part and a second mold part wherein a first cavity is formed between the first and second mold parts and the injected material is received therein during the first injection molding step. The solar cell arrangement may then be arranged on the first mold part before the first injection molding step is performed.

Optionally, the mold may also comprise a third mold part. A second cavity may then be formed between the partially manufactured photovoltaic module and the third mold part, wherein the second cavity may be configured to receive material injected into the mold during the second injection molding step. Such a mold configuration allows for a two-step injection molding process with, optionally, two different injection molding compositions and/or different pressures.

The process may comprise further molding steps (e.g., a third injection molding step), depending on the shape to be manufactured, the layers to be provided, and/or the materials to be used. For example, an elastomeric material (e.g., a thermoplastic elastomer) could be molded to the photovoltaic module for providing one or more sealing components (e.g., sealing profiles for movable components of a structure or vehicle).

Preferably one or more mounting brackets, one or more mounting holes, one or more support structures, one or more protective frames, and/or or one or more junction boxes for connecting several cells and/or several strings of cells of the solar cell arrangement are injection molded to the photovoltaic module. Optionally, the one or more mounting brackets, the one or more mounting holes, the one or more support structures, the one or more protective frames, and/or the one or more junction boxes may be integrally formed with the front layer and/or with the back layer when injection molding said layer. Such a step may be advantageous when the photovoltaic module is to be included in a larger structure such as a rooftop or an automobile panel, such that the module is immediately usable and further assembly steps are avoided.

The protective frame may at least partially or completely surround the photovoltaic module, preferably around its narrower edges. Such frame may, for example, protect the module against side impacts.

The one or more mounting brackets may allow to attach the photovoltaic module to another structure. The one or more mounting holes may be provided in said mounting brackets in order to facilitate the attachment. The one or more mounting brackets may extend from the protective frame.

The one or more support structures may comprise one or more ribs. The ribs may intersect each other and may optionally form a honeycomb structure. Optionally, the back layer of the photovoltaic module may comprise a first major surface facing the front layer and a second major surface opposite the first major surface and the support structure may be arranged on the second major surface. Such a support structure may help to physically support the photovoltaic module and protect the photovoltaic cells from damage. The ribs may be integrally formed with the back layer. The rib or ribs may be longer (preferably in a direction along the back layer) than they are tall (preferably in a direction away from the back layer). The ribs may form a mesh and/or latticework.

Preferably, the method may also include a step of providing an external electrical connecting means of the photovoltaic module onto the front and/or back layer of the photovoltaic module. The external electrical connecting means may be provided after the injection molding steps have been performed.

Optionally, at least a portion of the back layer of the photovoltaic module may include reinforcing fibers, for example reinforcing fibers surrounded by its polymer matrix. Such fibers may be made of carbon fibers, glass fibers, Kevlar fibers, or a combination thereof. In particular, a portion of the back layer forming the support structure may include such reinforcing fibers.

Preferably, each of the photovoltaic cells of the solar cell arrangement extends in a respective reference plane. At least some of the reference planes of adjacent cells intersect at an angle of more than 2°, more preferably an angle of more than 4° or more than 5°. Alternatively or additionally, the reference planes of adjacent cells may be parallel but offset from one another in a direction perpendicular to the reference planes. Either of these configurations allows for a photovoltaic module that takes on a curved, angled and/or complex form and provides for more versatility in the fabrication of photovoltaic modules.

Preferably, the photovoltaic cells are spaced apart from each other and are electrically interconnected by means of a conducting ribbon, wires or interconnectors. Alternatively or additionally, a positive side of one cell may be connected with a negative side of an adjacent cell.

The photovoltaic module may have two major surfaces, a first major surface configured to receive solar light so that the module produces electric energy and a second major surface opposite said first surface. The second major surface may be configured to face away from sunlight, e.g. towards the interior of a structure or vehicle. The first major surface may be configured to form an outer surface of the structure or vehicle on which the module is installed. For example, the first major surface may be configured to form the outer surface of a body panel (e.g. a side body panel), hood, door, trunk and/or roof of an automobile. As such, the module according to the present disclosure may be shaped as a body panel, hood, door, trunk and/or roof of an automobile. The support structure (e.g. the one or more ribs) may be provided along the second major surface of the module, i.e. on the side configured to face away from sunlight and/or towards the interior of a structure or vehicle to which the module is attached.

Preferably, the first and/or second major surface is not flat. More preferably, the first and/or second major surface is curved and/or angled and/or has a complex shape. For example, at least a portion of the first and/or second major surface may be curved in a three-dimensional manner. For example, a radius of curvature of the curved portion may be at least 10 cm, at least 40 cm, at least 50 cm, or at least 60 cm, or at least 80 cm. Alternatively or additionally, a radius of curvature of the curved portion may not be greater than 1000 cm, or may not be greater than 500 cm, or may not be greater than 300 cm, or may not be greater than 200 cm. Preferably, the injection molded layer is shaped as a non-flat layer. An outer surface of the injection molded layer facing towards the first major side surface of the module and/or an outer surface of the injection molded layer facing towards the second major side surface of the module may have a radius of curvature of less than 1000 cm, less than 500 cm, less than 300 cm, or less than 200 cm.

Meanwhile, the photovoltaic cells may be essentially flat or only slightly curved. Specifically, each of the photovoltaic cells may be flat or a radius of curvature of each of the photovoltaic cells may be larger than the radius of curvature of the first major surface and/or larger than the radius of curvature of the second major surface. In other words, a radius of curvature of each of the photovoltaic cells may be larger than the outer surface of the injection molded layer facing towards the first major side surface and/or larger than the outer surface of the injection molded layer facing towards the second major side surface of the module.

The methods according to the present disclosure may further include a step of providing a protective layer, in particular a protective layer or film, on a front side of the module (e.g., on the first major surface), preferably by injection molding the layer or film onto the front and/or onto the back layer. Materials that may be used for such protective layer or film are polypropylene (PP), polyurethane (PU) polycarbonate (PC), polyethylene (PE), polytetrafluoroethylene (PTFE), polyoxymethylene (POM), acrylonitrile butadiene styrene (ABS), a polyaryletherketone (PAEK), polyether ether ketone (PEEK), copolymers of polypropylene and ethylene, epoxy, phenolic, nylon, polystyrene (PS) and/or silicone (or any combination thereof). Any kind of transparent paint or spray coating could be used when not realized by injection molding.

As the skilled person will appreciate, injection molding is a process that is carried out at elevated temperature and/or pressure. For example, an injection pressure at a nozzle may be 5 MPa or more, 10 MPa or more, 20 MPa or more, 50 MPa or more, or 100 MPa or more. The process preferably includes plastification of a raw material provided as granulate, powder and/or stripes so that it becomes flowable. The molding machine may include a screw, preferably a reciprocating screw. The mold may be chilled and/or the material may cool off in the mold (e.g., when injection molding thermoplastics). Melt temperatures may be selected in accordance with the material to be molded. For example, melt temperatures above 150 °C, above 180 °C or above 200 °C may be used. In other cases, the mold may be heated in order to cross-link the polymer (e.g., when injection molding thermoset or elastomeric materials).

According to a further aspect the invention relates to a photovoltaic module comprising a solar cell arrangement, the solar cell arrangement preferably including a plurality of rigid photovoltaic solar cells and electrical connections connecting the cells. Optionally, the photovoltaic cells are rigid and/or the photovoltaic cells are crystalline silicon photovoltaic solar cells. Any of the types mentioned above may be used. The photovoltaic module further comprises a front layer and a back layer wherein the solar cell arrangement is at least partially or completely encapsulated between the front layer and the back layer. At least part of the front layer and/or at least part of the back layer is formed by injection molding. The photovoltaic module may be manufactured by any of the methods discussed above and any of the above-mentioned features may be provided therewith.

Preferably the photovoltaic cells are individual photovoltaic cells and the solar cell arrangement may further comprise a carrier that interconnects the individual photovoltaic cells. The carrier may be a layer playing a mechanical stabilization role. Alternatively or additionally, the solar cells could be glued onto a foil and/or soldered onto a substrate. In the case of the foil, it can be used as substrate or superstrate. Exceptionally, a solar cell arrangement can be composed of only one solar cell. The solar cell arrangement may include a string of cells.

The inclusion of a carrier may allow for a flexible interconnection of the photovoltaic cells and to protect the electrical connections without substantially restricting the physical placement of the photovoltaic cells relative to one another.

As described above, the photovoltaic cells of the photovoltaic module may be at least partially or completely encapsulated in an encapsulation gel or liquid. Such encapsulation provides further protection of the photovoltaic cells from the elements and may also help maintain the integrity of the photovoltaic cells during the injection molding process.

As further described above, the front and/or the back layer of the photovoltaic module may include a first molded layer formed by injection molding and a second molded layer formed by injection molding.

Alternatively or additionally, the front layer and/or the back layer may include a sheet of polymeric foil. Said polymeric foil may help protect the solar cells from the environment or protect them during the injection molding process.

Preferably the solar cell arrangement does not comprise a rigid sheet. Said lack of a rigid sheet, e.g. for mounting the solar cell arrangement, allows for a more flexible placement of the photovoltaic cells and allows for a wider range of shapes to be attained from the injection molding process. The method according to the present invention preferably does not include the attachment of the solar cell arrangement to a pre-fabricated rigid sheet (e.g., a pre-fabricated sheet made from glass or PC).

Preferably the back layer also includes a support structure, preferably wherein the support structure comprises a plurality of ribs, more preferably wherein the ribs intersect each other, even more preferably wherein the support structure is a honeycomb structure. The support structure may aid in maintaining the stiffness and strength of the photovoltaic module and protect the solar cells from damage.

Optionally, at least a portion of the back layer comprises reinforcing fibers in a polymer matrix.

According to a further aspect, the present invention relates to a vehicle (e.g., a car, bus, truck, train, or plane) or building (e.g., a house) including the photovoltaic module in accordance with the invention. In particular, the photovoltaic module itself may be shaped as a body panel, a hood, a door, a trunk or a roof of such vehicle. Optionally, the photovoltaic module may include molded brackets and inserts in order to be attached directly to a structure or frame (e.g., a vehicle structure and/or frame) and/or hinges (e.g., hinges connected to said vehicle structure and/or frame). These brackets and inserts may be injection molded and/or integrally formed with the module. In other words, additional structures - such as additional frames (e.g. metallic frames)- or functional elements extending around and/or holding the module may not be required for connecting and/or supporting the module, e.g. connecting and/or supporting the module at a vehicle structure and/or frame and/or hinges connected to said structure and/or frame.

### Brief Description of the Drawings

The subject matter of the invention will be explained in more detail in the following with reference to preferred exemplary embodiments which are illustrated in the attached drawings, in which:
- Fig. 1: schematically shows a perspective view of a photovoltaic module including a polymeric film;
- Fig. 2: schematically shows a perspective view of a photovoltaic module with encapsulated solar cells;
- Fig. 3: schematically shows a perspective view of a photovoltaic module with two injection molded layers;
- Fig. 4a: schematically shows a cross-sectional view of an injection molding mold or die for an injection molding process;
- Fig. 4b: schematically shows a cross-sectional view of an injection molding mold or die for a second step of a two-step injection molding process;
- Fig. 5: schematically shows a photovoltaic module including a protective frame and mounting brackets;
- Fig. 6: schematically shows a cross-sectional view of the photovoltaic module of Fig. 5;
- Fig. 7: schematically shows a cross-sectional view of a curved photovoltaic module wherein the photovoltaic cells are positioned at an angle to one another;
- Fig. 8: schematically shows a cross-sectional view of a curved photovoltaic module wherein the photovoltaic cells are positioned offset from one another.
- Fig. 9a: schematically illustrates a cross-sectional view of a photovoltaic module including representative electrical connections.
- Fig. 9b: schematically illustrates a cross-sectional view of a photovoltaic module including representative electrical connections and a release loop.
- Fig. 9c: shows an exemplary configuration of a release loop.
- Fig. 9d: shows another exemplary configuration of a release loop.

### Detailed Description

In the present description the term "solar cell" preferably refers to a photovoltaic cell which converts radiant light energy into electricity through the photovoltaic effect. A solar cell arrangement includes at least one solar cell provided with electrically connective elements. The solar cell arrangement may comprise a plurality of solar cells which are electrically interconnected. The solar cells may be connected in series or in parallel or any combination thereof.

Many different types of solar cells which are known or commercially available may be employed in the present invention. Solar cell materials may include any kind of solar cells, including single to multi-junction solar cells and/or monocrystalline cells. For example, cadmium tellurides, gallium arsenides, amorphous silicon or crystalline silicon or III-V compounds photovoltaic cells may be used. The solar cells may be rigid or flexible. The present invention lends itself particularly well to rigid solar cells, as other methods of photovoltaic module formation may not be suitable for use with rigid solar cells. Injection molding can provide a curved or complex geometry to the photovoltaic module which other methods of fabrication may not be able to provide without damaging a rigid solar cell.

The solar cells of the solar cell arrangement may preferably be connected in a string configuration, which includes multiple solar cells aligned in a row and connected in series. The positively charged face of the solar cell may then be connected with the negative side of the neighboring solar cell. The electrical connections between each solar cell may be formed by means of electrically conducting ribbons, wires or interconnectors.

In general, the solar cell arrangement may include a number of other components or substrates. The solar cell arrangement may include bus bars and a mounting substrate or superstrate. Such a mounting substrate may be a flexible substrate or superstrate, such as a polymer foil. However, also a rigid substrate, such as glass or polycarbonate may be useful.

The present invention is directed to a method for manufacturing a photovoltaic module using an injection molding process. The photovoltaic module comprises a front layer and a back layer, with a solar cell arrangement encapsulated between the front and the back layers. The solar cell arrangement includes a plurality of photovoltaic cells, which may be rigid. In some cases the photovoltaic cells may be crystalline silicon photovoltaic cells or any of the types mentioned above. The solar cell arrangement includes electrical connections between the individual solar cells and optionally a substrate or superstrate.

Formation of the photovoltaic module includes providing a solar cell arrangement as described above and then providing a layer to the solar cell arrangement by injection molding at least part of the front or back layer to the solar cell arrangement.

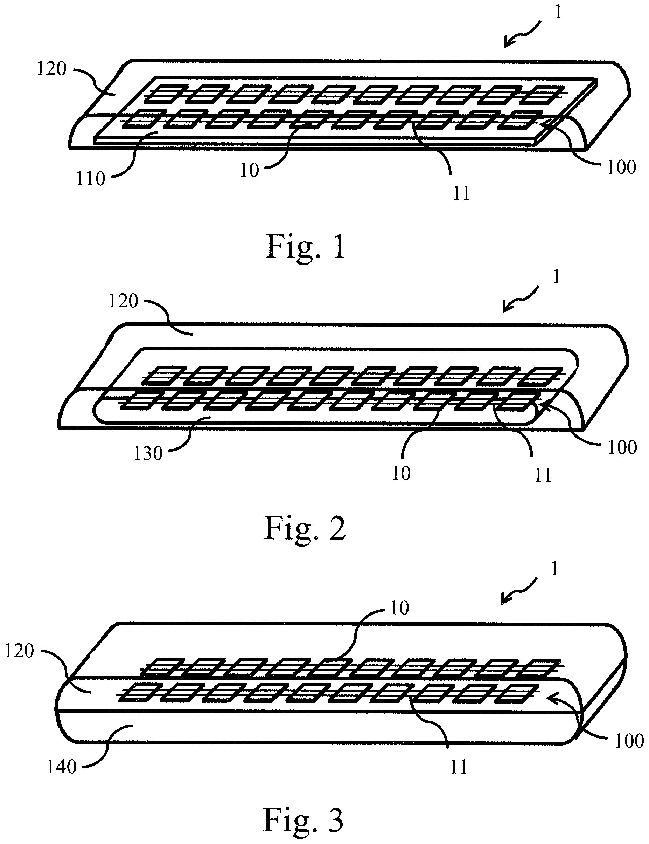

More specifically, Fig. 1 shows a photovoltaic module 1 with one possible configuration of the solar cell arrangement 100. The solar cell arrangement 100 includes strings of photovoltaic cells 10 and electrical connections 11 electrically connecting the cells 10. Although two strings of cells 10, with ten cells each are shown here, it is to be understood that any number of solar cells 10 may be present including a single solar cell 10. Preferably, the solar cell arrangement 100 includes at least 4, at least 10, or at least 20 solar cells.

The solar cells of Fig. 1 may be provided on a surface of a polymeric foil 110 in linearly oriented rows. In this configuration the solar cells may be bonded to the polymeric foil 110, preferably through the application of heat, thus melting the polymeric foil 110 to the solar cells 10 and/or embedding the cells in the foil 110. Alternatively or additionally, the foil and the solar cells may be joined together by a lamination process and/or adhesive. Alternately, the solar cells 10 may only rest upon the polymeric sheet. In some instances the polymeric sheet may comprise polyester thermoplastic chosen from the list of thermoplastics disclosed herein. The polymeric sheet may alternatively comprise EVA, optionally in combination with an additional polymer. In this configuration the polymeric foil 110 and the solar cells 10 are placed within an injection molding apparatus. Then, an injection molding process is performed, with the injection molding material 120 being deposited either directly on to the solar cells 10 and/or directly onto the polymeric foil 110.

The injection molded material 120 provides structure and protection from the elements for the solar cell arrangement. The injection molded material 120 may be optically transparent to allow light radiation to pass therethrough, in particular when the injection molded material 120 is deposited on the sun-facing side of the solar cells 10. Alternatively, for example if the injection molded material 120 is deposited on the polymeric foil 110 (e.g., on the side opposite to that on which the solar cells 10 are arranged), the injection molded material 120 may be optically opaque and/or colored.

A preferential configuration for the photovoltaic module 1 is to have the injection molded material 120 deposited on the side of the solar cell arrangement 100 opposite of the polymeric foil 110.

It is also preferred that in the configuration of Fig. 1 no rigid sheet is provided for the solar cells 10. Specifically, it is preferred that a further lamination of the solar cells with a polycarbonate and/or glass sheet is not performed and/or not required. In this way, the injection molded material 120 may provide the structure and support to the solar cell arrangement 100 that would otherwise be lacking without the presence of a rigid glass sheet or the like.

Fig. 2 depicts a perspective view of another possible configuration of a photovoltaic module 1 with a solar cell arrangement 100. In this variation, the solar cell arrangement 100 has been encapsulated in an encapsulant 130 before the deposition of the injection molded material 120. The encapsulant 130 may partially or fully enclose the solar cell arrangement 100. The encapsulant may be any number of materials. Preferably, an encapsulant liquid or gel is provided, for example an encapsulant liquid or gel based on ethylene-vinyl acetate (EVA). The encapsulant liquid and/or gel is poured, deposited, or otherwise applied to the solar cell arrangement 100 and then either allowed to cure over time or cured using heat, UV radiation, or through other chemical means to achieve a hardened encapsulant 130.

The encapsulation of the solar cells 10 may also be combined with the presence of a polymeric foil 110 as in Fig. 1, for example. For example, the solar cell arrangement may first be encapsulated within encapsulant 130 and then arranged and/or bonded to a polymeric foil 110. In this case the injection molded material 120 preferably is deposited on the side of the solar cell arrangement 100 opposite of the polymeric foil 110.

It is also possible to arrange and/or bond the solar cell arrangement 100 to the polymeric foil 110 and subsequently encapsulate both within the encapsulant 130. In this case, the injection molded material 120 may be deposited on either side of the encapsulated solar cell arrangement.

Fig. 3 illustrates a perspective view of another possible configuration of a photovoltaic module 1 and a solar cell arrangement 100. In this case the photovoltaic module 1 has undergone two different injection molding steps. A first injection molded layer 120 has been injection molded on a first surface (in Fig. 3 the upper surface) of the solar cell arrangement 100 and a second injection molded layer 140 has been injection molded on a second surface (in Fig. 3 the lower surface) of the solar cell arrangement 100. In said configuration the first injection molded layer 120 and/or the second injection molded layer 140 may be formed directly onto the solar cells 10. The configuration of Fig. 3 may optionally be combined with the polymeric foil 110 and/or the encapsulant 130, as shown, for example, in Figs. 1 and 2.

As rigid photovoltaic cells may be easily broken or cracked, in this embodiment the first injection molding step may be performed at a first pressure lower than a second pressure of the second injection molding step. A lower pressure may help to protect the solar cells from damage during the injection molding process, such as cracking. Also movement of the solar cells and/or the solar cell arrangement may be prevented.

Once the solar cells have been provided with the support and protection of the first injection molded layer 120, the second injection molding step may be performed at a higher pressure. The first and/or second pressure may be 1 MPa and more, 5 MPa and more, 10 MPa and more, 20 MPa and more, 50 MPa and more, or 100 MPa and more. Without wanting to be bound by these values (or any other values disclosed herein), the first pressure may be less than 20 MPa, less than 10 MPa or less than 5 MPa.

One or both of the injection molded layers 120, 140 may be transparent. Alternatively, one of the injection molded layers may be transparent while the other is opaque. Additionally, the first and second injection molded layers 120, 140 may be of different colors or have different compositions. The first injection molded layer 120 may include a different type of polymer than the second injection molded layer 140. Optionally, the first injection molded layer 120 includes a first thermoplastic polymer forming the matrix of the first molded layer, and the second injection molded layer 140 includes a second thermoplastic polymer forming the matrix of the second molded layer. The first and second thermoplastic polymers may have different structural formulas.

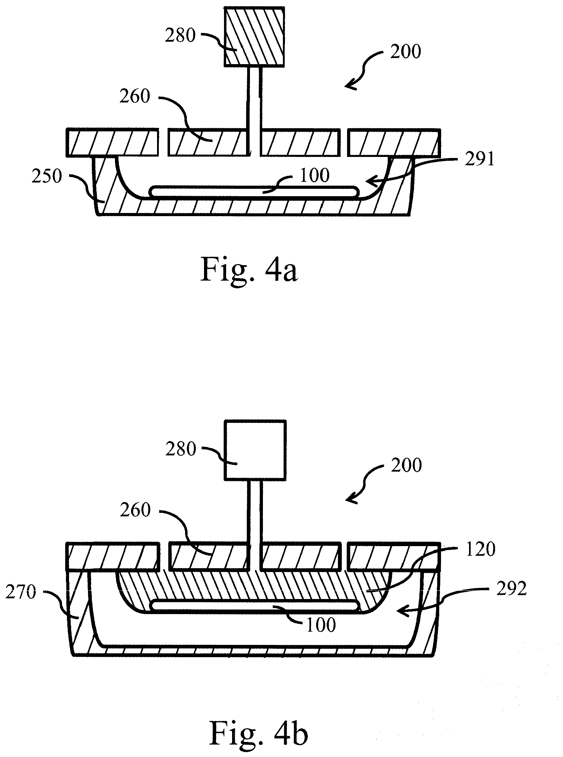

Figs. 4a and 4b illustrate an example of the molding process. The first injection molding step takes place inside an injection molding die 200 as shown in Fig. 4a. The die comprises at least a first mold part 250 and a second mold part 260, however it is understood that the mold may comprise further molding parts to facilitate different types of injection molding processes. A cavity 291 is formed between the mold parts 250, 260 wherein the solar cell arrangement 100 can be placed. Optionally, the first mold part 250 may have a recess or a number of recesses in which the solar cell arrangement 100 or the individual solar cells 10 may be placed. Such a recess may help to keep the solar cells 10 in a particular position and configuration during the injection molding process. An injection molding material, such as a thermoplastic, is injected into the molding die 200 from a reservoir 280 via a injection molding machine. The injection molding material then forms a layer on one side of the solar cell arrangement 100.

Another additional injection molding step may optionally be performed by removing one of the first or second mold parts and replacing it with a third mold part 270 as shown in Fig. 4b. Another cavity 292 is then formed in the molding die with the solar cell arrangement 100 located inside. Subsequently a second injection molding step is performed on the side of the solar cell arrangement 10 opposite the first side. In this way the solar cell arrangement 100 may be completely encapsulated and/or enclosed by injection molding material.

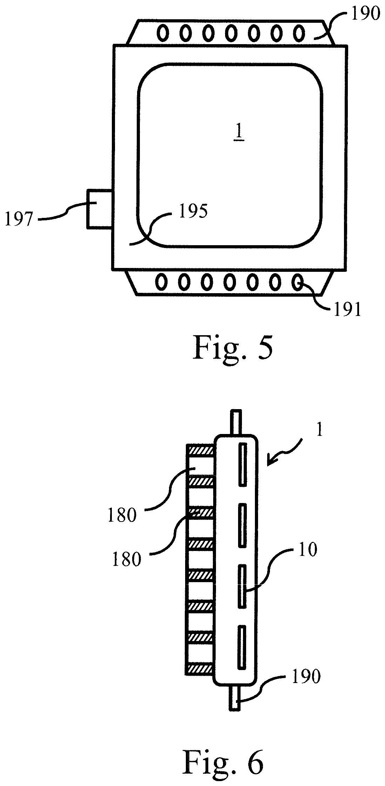

As further illustrated in Figs. 5 and 6, one benefit of manufacturing a photovoltaic module 1 via an injection molding process is the integral inclusion and/or integral formation of auxiliary structures. For instance, one or more mounting brackets 190 may be integrally molded with the photovoltaic module 1. This may reduce the number of steps required to produce the finished photovoltaic module 1 and render the module immediately ready for mount on, for instance, the frame of a vehicle. Alternatively or additionally, mounting holes 191, may be formed integrally in the front layer and/or the back layer of the module 1, in a protective frame 195, and/or in the one or more mounting brackets 190 during the injection molding process. Other support structures, such as the protective frame 195 may also be integrally formed during the injection molding process. Advantageously, a junction box 197 for electrically connecting the solar cells 10 (e.g. to further electronics of the structure or vehicle) may be integrally injection molded with the photovoltaic module (e.g., with the protective frame 195).

As shown in more detail in Fig. 6, the photovoltaic module may optionally include a support structure, which also may be integrally formed during the injection molding process. The support structure may help in providing mechanical strength and rigidity to the module 1. Such a support structure may take on any configuration, such as a plurality of ribs 180. The ribs 180 can be, for example, parallel to each other and/or may intersect one another forming a latticework support structure. One example of such a support structure comprises intersecting ribs 180 which form a honeycomb structure. Preferably such a honeycomb support structure is included on the back side of the module 1 that is not configured for receiving the sunlight therethrough.

During the injection molding process, one of the injection molded layers may also be formed using injection molding material comprising reinforcing fibers in a polymer matrix. Such reinforcing fibers may be made of carbon, glass, and/or Kevlar.

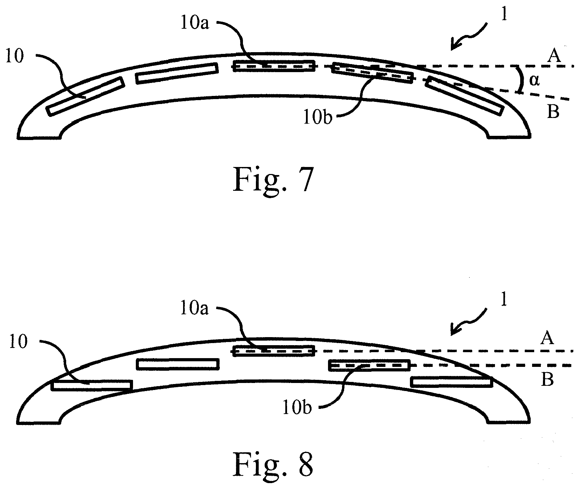

Figs. 7 and 8 illustrate further example configurations of the injection molded photovoltaic modules. In Figs. 7 and 8 the solar cells may be completely encapsulated and/or enclosed within the injection molded material. The solar cell arrangement and the front and back layers of the photovoltaic module may include any number of other features as described above, including but not limited to a polymeric foil, encapsulation fluid, support structures, and/or reinforcing fibers. They may be produced by any of the methods discussed in the present disclosure.

Figs. 7 and 8 illustrate how photovoltaic cells 10, in particular rigid photovoltaic cells, may be used while still providing the injection molded photovoltaic module 1 with a curved or angled shape. In particular a sun-facing outer surface of the module 1 (e.g. an outer surface of the front layer), which is preferably transparent, may be provided with such curved or angled outer shape.

In Fig. 7, the photovoltaic module 1 itself is curved and may thus be integrated within a larger construction requiring more complex geometries. The solar cells 10 are located within the photovoltaic module 1, wherein each solar cell 10 extends within a certain plane. For instance, solar cell 10a extends within plane A and solar cell 10b extends within plane B. As illustrated, solar cells 10a and 10b are fixed at an angle relative to one another such that an angle α is formed between plane A and plane B. This intersection may be at an angle of more than 2°, more preferably an angle of more than 4° or more than 5°. This enables the photovoltaic module 1 to take on a curved and/or angled form.

Further geometries are also considered in which the angle of intersection may even be up to 30° or greater, up to 45° or greater, or even up to 90° or greater. In such a way, structurally complex photovoltaic modules may be created for integration into larger structures.

Fig. 8 illustrates an alternative arrangement of the solar cells 10, wherein the solar cells 10 may be embedded within the photovoltaic module 1. The photovoltaic module 1 takes on a curved geometry in this particular example, however, it may assume any number of complex geometries, including a flat geometry or an angled geometry. In this variation the solar cells 10 each extend within a plane. For instance solar cell 10a extends within plane A and solar cell 10b extends within plane B. In the configuration shown in Fig. 8, planes A and B are substantially parallel to one another. However, plane A and plane B are offset from one another in a direction perpendicular to the direction of extension of the planes A and B. This provides an alternate method for arranging individual solar cells 10 within a photovoltaic module 1 such that the photovoltaic module 1 takes on complex geometries, including a curved geometry. As the skilled person will appreciate, the arrangements shown in Figs. 7 and 8 may also be combined.

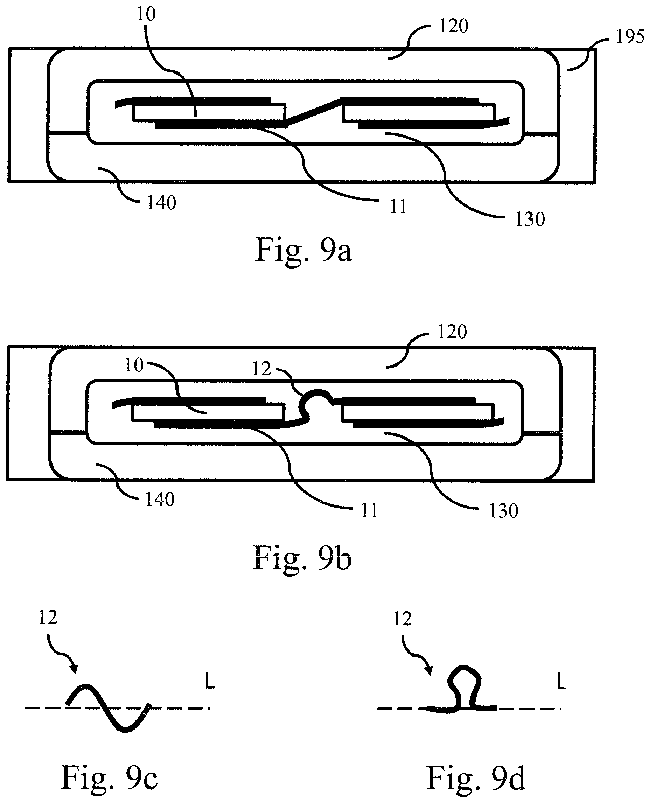

Fig. 9a illustrates an example of the photovoltaic module including encapsulated solar cells 10 and representative electrical connections 11 in the form of conducting ribbons or wires. In the present example the negative side of one solar cell may be electrically connected to the positive side of the next solar cell in a series arrangement.

The cells and the electrical connections in the present arrangement are encapsulated within a hardened encapsulant 130. As described above, a polymer foil 110 may be included instead of or in addition to the encapsulant 130. However, the encapsulant 130 and the polymer foil 110 could also be omitted.

A first injection molded layer 120 and a second injection molded layer 140 encompass the encapsulated solar cell arrangement. The present system depicts two solar cells 10, however any number of solar cells may be included within such an embodiment in a similar manner. Furthermore, it is understood that the solar cells 10 of the present arrangement can be injection molded in an angled or an offset pattern, such as in, for example, Figs. 7 and 8, so as to form a non-planar photovoltaic module. A single injection molded layer could be provided instead of layers 120, 140 if desired.

An optional frame 195 is also shown, which may be injection molded to the solar cell arrangement. The frame 195 may be manufactured in a third injection molding step (e.g., from a third material). Alternatively, the frame could be manufactured from the material used for the first injection molded layer 120 or from the material used for the second injection molded layer 140, e.g., when injection molding said first layer 120 or said second layer 140, respectively.

Fig. 9b illustrates an exemplary embodiment of a photovoltaic module which may include all of the features as illustrated in Fig. 9a. Furthermore, a release loop 12 is shown. The release loop 12 may be a conducting wire or ribbon preformed in a curved or looped shape. The release loop 12 forms a part of the electrical connections between neighboring solar cells 10. When a photovoltaic module undergoes thermal stresses, such as heating, the component materials of the photovoltaic module may not response equivalently to the change in temperature. For instance, some materials may expand more than others. This can place mechanical stress upon the individual components of the photovoltaic module. By including a release loop 12, such as illustrated herein, the release loop 12 may either partially straighten or further coil in order to compensate for mechanical stresses generated by thermal changes in the photovoltaic module. Such release loops 12 may be included at only select electrical junctions within the photovoltaic module or as a part of each electrical connection between individual elements and/or individual cells.

Figs. 9c and 9d show further exemplary configurations of release loops 12. In Fig. 9c, an undulating shape is shown. In Fig. 9d, a looped portion is shown. As will be appreciated, each of these designs includes one or more portions extending away from an axis L along which the connection generally extends in order to accommodate for thermal expansion and/or contraction.

While the invention has been illustrated and described in detail in the drawings and foregoing description, such illustration and description are to be considered illustrative or exemplary and non-restrictive; the invention is thus not limited to the disclosed embodiments. Variations to the disclosed embodiments can be understood and effected by those skilled in the art and practicing the claimed invention, from a study of the drawings, the disclosure, and the appended claims. In the claims, the word "comprising" does not exclude other elements or steps, and the indefinite article "a" or "an" does not exclude a plurality and may mean "at least one".

The following are preferred aspects of the invention:
1. Method for manufacturing of a photovoltaic module,
   the module comprising at least a front layer and at least a back layer and a solar cell arrangement encapsulated between the front layer and the back layer, the solar cell arrangement including a plurality of photovoltaic cells, preferably rigid photovoltaic cells, more preferably crystalline silicon photovoltaic cells; and electrical connections connecting the cells;
   the method at least comprising the steps of:
      - providing the solar cell arrangement; and
      - providing a molded layer by injection molding at least part of the front layer and/or at least part of the back layer onto the solar cell arrangement.
2. Method according to aspect 1, further comprising the steps of:
   - providing a polymeric foil;
   - arranging the solar cell arrangement on the foil;
      wherein the injection molding step is performed directly onto the solar cells and/or onto the foil.
3. Method according to aspect 2, wherein the molded layer is the front layer or the back layer, preferably wherein the foil forms the other one of the front layer and the back layer, more preferably wherein the front layer and/or the back layer forms an exposed outer surface of the photovoltaic module.
4. Method according to aspect 2 or 3, wherein the molded layer is injection molded onto a side of the solar cell arrangement opposite the foil.
5. Method according to any of aspects 2 to 4, further comprising the step of:
   - joining the foil and the solar cell arrangement together before injection molding the molded layer, preferably by the application of heat.
6. Method according to any of aspects 2 to 5, wherein the foil and the solar cell arrangement are joined together by a lamination process, preferably a lamination process excluding the use of a rigid sheet, in particular a rigid sheet made of glass.
7. Method according to any one of the preceding aspects, further comprising the step of:
   - encapsulating the solar cell arrangement at least partially or completely in an encapsulation polymer, wherein the front layer and/or the back layer are injection molded directly onto the encapsulated solar cell arrangement.
8. Method according to any one of the preceding aspects, wherein the step of injection molding includes:
   - a first injection molding step wherein a first molded layer is injection molded onto the cells;
   - a second injection molding step wherein a second molded layer is injection molded onto the cells,
      preferably wherein the first injection molding step is performed directly on the solar cells.
9. Method according to aspect 8, wherein the first injection molding step is carried out at a lower pressure than the second injection molding step.
10. Method according to aspect 8 or 9,
   wherein a first polymeric composition is injected in the first injection molding step and a second polymeric composition is injected in the second injection molding step;
   preferably wherein
      - one of the first and second compositions is transparent while the other is translucent or opaque;
      - wherein the first and second compositions have different colours;
      - wherein the first composition includes a different type of polymer than the second composition, preferably wherein the first composition includes a first thermoplastic polymer forming the matrix of the first molded layer and the second composition includes a second thermoplastic polymer forming the matrix of the second molded layer, wherein the first and second thermoplastic polymers have a different structural formula.
11. Method according to any of aspects 8 to 10,
   wherein the first injection molding step is carried out in a mold comprising at least a first mold part and a second mold part;
   wherein the solar cell arrangement is arranged on the first mold part;
   wherein a cavity is formed between the solar cell arrangement and the second mold part, the cavity being configured to receive material injected into the mold during the first injection molding step.
12. Method according to aspect 11,
   wherein the mold comprises a third mold part;
   wherein a second cavity is formed between the solar cell arrangement and the third mold part, the second cavity being configured to receive material injected into the mold during the second injection molding step.
13. Method according to aspect 11 or 12,
   wherein each cell of the solar cell arrangement is arranged on a curved or flat surface section of the first mold part; and/or
   wherein each cell of the solar cell arrangement is arranged in a recess of the first mold part.
14. Method according to any of the previous aspects, wherein the solar cells are individual solar cells and the solar cell arrangement further comprises a carrier between the individual solar cells.
15. Method according to any one of the previous aspects, wherein
   - one or more mounting brackets; and/or
   - one or more mounting holes; and/or
   - a support structure; and/or
   - a protective frame; and/or
   - a junction box for connecting several cells or several strings of cells of the solar cell arrangement
      is injection molded to the photovoltaic module, preferably wherein the mounting bracket, the mounting hole, the support structure, the protective frame, and/or the junction box is integrally formed in the front layer and/or in the back layer when injection molding said layer.
16. Method according to aspect 15,
   wherein the support structure comprises a plurality of ribs, preferably wherein the ribs intersect each other, more preferably wherein the support structure is a honeycomb structure;
   preferably wherein the back layer comprises a first major surface facing the front layer and a second major surface opposite said first major surface, wherein the support structure is arranged on the second major surface.
17. Method according to any one of the previous aspects, further including a step of:
   - providing an external electrical connecting means of the module onto the front and/or back layer.
18. Method according to any one of the previous aspects, wherein at least a portion of the back layer comprises reinforcing fibers in a polymer matrix, in particular a portion forming the support structure.
19. Method according to any one of the preceding aspects,
   wherein each cell of the solar cell arrangement extends in a respective reference plane,
   wherein at least some of the reference planes of adjacent cells intersect at an angle, preferably an angle of more than 2°, more preferably an angle of more than 4° or more than 5°, or
   wherein the reference planes of adjacent cells are parallel but offset from one another in a direction perpendicular to that of the reference planes.
20. Method according to any one of the previous aspects,
   wherein the solar cells are spaced apart from each other and electrically interconnect by means of conducting ribbons, wires, interconnectors, and/or wherein a positive side of one cell is connected with a negative side of an adjacent cell, preferably wherein the electrical connection between solar cells includes a release loop.
21. Method according to any one of the previous aspects, wherein the injection molded layer is shaped as a non-flat layer.
22. Method according to any one of the previous aspects, further comprising the step of:
   - providing a protective layer, in particular a protective film, on a frontside of the module, preferably by injection molding the film onto the front and/or onto the back layer.
23. A photovoltaic module comprising,
   a solar cell arrangement, the solar cell arrangement including a plurality of rigid solar cells, preferably crystalline silicon photovoltaic solar cells, and electrical connections connecting the cells;
   a front layer;
   a back layer;
   wherein the solar cell arrangement is encapsulated between the front layer and the back layer and at least part of the front layer and/or at least part of the back layer is formed by injection molding.
24. A photovoltaic module according to aspect 23, wherein the solar cells are individual solar cells and the solar cell arrangement further comprises a carrier that interconnects the individual solar cells.
25. A photovoltaic module according to aspects 23 or aspect 24, wherein the solar cell arrangement is at least partially or completely encapsulated in an encapsulation polymer.
26. A photovoltaic module according to any one of aspects 23 to 25, wherein the front layer or the back layer includes a first molded layer formed by injection molding and a second molded layer formed by injection molding.
27. A photovoltaic module according to any one of aspects 23 to 26, wherein the front layer or the back layer includes a sheet of polymeric foil.
28. A photovoltaic module according to any one of aspects 23 to 27, wherein the solar cell arrangement does not comprise a rigid sheet.
29. A photovoltaic module according to any one of aspects 23 to 28, wherein the back layer includes a support structure,
   preferably wherein the support structure comprises a plurality of ribs, more preferably wherein the ribs intersect each other, even more preferably wherein the support structure is a honeycomb structure.
30. A photovoltaic module according to any one of aspects 23 to 29, wherein at least a portion of the back layer comprises reinforcing fibers in a polymer matrix.

## Claims

1. Method for manufacturing of a photovoltaic module (1), the module (1) comprising at least a front layer and at least a back layer and a solar cell arrangement (100) encapsulated between the front layer and the back layer, the solar cell arrangement (100) including a plurality of photovoltaic cells (10), preferably rigid and/or crystalline silicon photovoltaic cells, and electrical connections (11) connecting the cells;
the method at least comprising the steps of:
- providing the solar cell arrangement (100); and
- providing a molded layer (120) by injection molding at least part of the front layer and/or at least part of the back layer onto the solar cell arrangement (100).

2. Method according to claim 1, further comprising the steps of:
- providing a polymeric foil (110);
- arranging the solar cell arrangement (100) on the foil (110);
wherein the injection molding step is performed directly onto the photovoltaic cells (10) and/or onto the foil (110), preferably wherein the molded layer (120) is injection molded onto a side of the solar cell arrangement (100) opposite the foil (110).

3. Method according to claim 2, further comprising the step of:
- joining the foil (110) and the solar cell arrangement (100) together before injection molding the molded layer (120), preferably by the application of heat or by a lamination process, more preferably wherein the heat or lamination process excludes the use of a rigid sheet.

4. Method according to any one of the preceding claims, further comprising the step of:
- encapsulating the solar cell arrangement (100) at least partially or completely in an encapsulation film, gel and/or liquid (130), wherein the front layer and/or the back layer are injection molded directly onto the encapsulated solar cell arrangement (100).

5. Method according to any one of the preceding claims, wherein the step of injection molding includes:
- a first injection molding step wherein a first molded layer (120) is injection molded onto the solar cell arrangement (10);
- a second injection molding step wherein a second molded layer (140) is injection molded onto the solar cell arrangement (10),
preferably wherein at least the first injection molding step is performed directly on the photovoltaic cells (10).

6. Method according to claim 5,
wherein the first injection molding step is carried out in a mold comprising at least a first mold part (250) and a second mold part (260);
wherein the solar cell arrangement (100) is arranged on the first mold part (250);
wherein a first cavity (291) is formed between the solar cell arrangement(100) and the second mold part (260), the cavity (291) being configured to receive material injected into the mold during the first injection molding step.

7. Method according to claim 6,
wherein the mold comprises a third mold part (270);
wherein a second cavity (292) is formed between, on the one hand, the solar cell arrangement (100) and first molded layer (120) and, on the other hand, the third mold part (270), the second cavity (292) being configured to receive material injected into the mold during the second injection molding step.

8. Method according to any one of the previous claims, wherein
- one or more mounting brackets (190); and/or
- one or more mounting holes (191); and/or
- a support structure; and/or
- a protective frame (195); and/or
- a junction box (197) for connecting several cells (10) or several strings of cells of the solar cell arrangement (100);
is injection molded to the photovoltaic module (1), preferably wherein the mounting bracket (190), the mounting hole (191), the support structure, the protective frame (195), and/or the junction box (197) is integrally formed with the front layer and/or with the back layer when injection molding said layer.

9. Method according to claim 8,
wherein the support structure comprises a plurality of ribs (180), preferably wherein the ribs (180) intersect each other, more preferably wherein the support structure is a honeycomb structure;
preferably wherein the back layer comprises a first major surface facing the front layer and a second major surface opposite said first major surface, wherein the support structure is arranged on the second major surface.

10. Method according to any one of the preceding claims,
wherein each cell (10a, 10b) of the solar cell arrangement (100) extends in a respective reference plane (A, B),
wherein at least some of the reference planes (A, B) of adjacent cells (10a, 10b) intersect at an angle (α), preferably an angle (α) of more than 2°, more preferably an angle (α) of more than 4° or more than 5°, and/or
wherein the reference planes (A, B) of adjacent cells (10a, 10b) are parallel but offset from one another in a direction perpendicular to that of the reference planes (A, B).

11. A photovoltaic module (1) comprising,
a solar cell arrangement (100), the solar cell arrangement (100) including a plurality of photovoltaic cells (10), preferably rigid and/or crystalline silicon photovoltaic cells, and electrical connections (11) connecting the photovoltaic cells (10);
a front layer;
a back layer;
wherein the solar cell arrangement (100) is enclosed between the front layer and the back layer and at least part of the front layer and/or at least part of the back layer is formed by injection molding.

12. A photovoltaic module (1) according to claim 11, wherein the solar cell arrangement (100) is at least partially or completely encapsulated in an encapsulation film, gel and/or liquid (130).

13. A photovoltaic module (1) according to claim 11 or claim 12, wherein the front layer or the back layer includes a first molded layer (120) formed by injection molding and a second molded layer (140) formed by injection molding, preferably wherein the solar cell arrangement (100) does not comprise a rigid sheet.

14. A photovoltaic module (1) according to any one of claims 11 to 13, wherein the front layer or the back layer includes a sheet of polymeric foil (130).

15. A photovoltaic module (1) according to any one of claims 11 to 14, wherein the back layer includes a support structure,
preferably wherein the support structure comprises a plurality of ribs (180), more preferably wherein the ribs (180) intersect each other, even more preferably wherein the support structure is a honeycomb structure.
